# EUROPEAN PATENT SPECIFICATION

(11) **EP 4 296 655 B1**
(45) Date of publication and mention of the grant of the patent: **20.05.2026**
(21) Application number: 22180574.0
(22) Date of filing: 22.06.2022
(51) Int. Cl.: G01N 21/952, G01B 11/25, G01B 11/245

(54) **METHOD AND SYSTEM FOR INSPECTING AN INSULATION OF A HIGH VOLTAGE CABLE**
VERFAHREN UND SYSTEM ZUR PRÜFUNG EINER ISOLATION EINES HOCHSPANNUNGSKABELS
PROCÉDÉ ET SYSTÈME D'INSPECTION D'ISOLATION D'UN CÂBLE HAUTE TENSION

(43) Date of publication of application: 27.12.2023
(73) Proprietor: NKT HV Cables AB, 371 60 Lyckeby (SE)
(72) Inventor: HUELSMANN-EMDEN, Bernhard, Nordenham (DE)
(74) Representative: Kransell & Wennborg KB

(56) References cited:
- WO-A1-2019/197530
- CN-A- 105 953 756
- JP-A- 2018 147 803
- QIN XINYAN ET AL: "A Novel Method to Reconstruct Overhead High-Voltage Power Lines Using Cable Inspection Robot LiDAR Data", REMOTE SENSING, vol. 9, no. 7, 22 July 2017 (2017-07-22), CH, pages 753, XP055969546, ISSN: 2072-4292, Retrieved from the Internet <URL:http://dx.doi.org/10.3390/rs9070753> DOI: 10.3390/rs9070753
- HE HAOHUI ET AL: "Measurement of 3D shape of cable sealing layer based on structured light binocular vision", SPIE SMART STRUCTURES AND MATERIALS + NONDESTRUCTIVE EVALUATION AND HEALTH MONITORING, 2005, SAN DIEGO, CALIFORNIA, UNITED STATES, SPIE, US, vol. 11781, 28 February 2021 (2021-02-28), pages 117811L - 117811L, XP060139181, ISSN: 0277-786X, ISBN: 978-1-5106-4548-6, DOI: 10.1117/12.2591369

## Description

### Field of the disclosure

The present disclosure relates to a method for inspecting an insulation of a high voltage cable. Aspects relate to a system for inspecting an insulation of a high voltage cable.

### Technical background:

High voltage (HV) cables generally include, from inside to outside: a conductor, an insulating layer, shield wires, and an outer sheath. **In** particular, an inner conductive layer is provided between the conductor and the insulating layer and an outer conductive layer is provided on an outer side of the insulating layer. Processing of the HV cable is required for installing a HV cable accessory, like for example a cable termination or a cable joint. The processing includes peeling the outer conductive layer and may include subsequent grinding of the insulating layer, depending on the voltage rating of the cable. A conventional method of inspecting the processing result is a manual inspection of the insulating layer relying on tactile feedback, particularly by sliding a finger over the processed area. The quality of a manual inspection depends on the experience of the inspecting person.

Other conventional methods include measurement with a slide gauge or with a diameter tape. **In** general, conventional methods of inspecting the insulation of a HV cable after processing have limitations as to their reliability and replicability.

It is therefore an object of the present disclosure to overcome at least some of the above-mentioned problems in the prior art at least partially.

WO2019/197530 A1 discloses surface scanner for surface defect detection of a cable comprising a measuring part and an analysis part. The measuring part comprises non-contact distance measurement sensors, the cable is positionable between the sensors such that beams of the sensors are directable to the outer surface of the cable to sample areas at a circumference of the cable for a length of the outer surface of the cable in a run direction of the cable for providing measurement data, and the analysis part comprises a receiver for the measurement data, a processor for processing the measurement data providing defect detection data and a continuous 3D topographic map of the outer surface of the cable, the analysis part comprising a neural network trained for detecting surface defects of the cable and outputting surface defects detection data.

JP 2018 147803 A discloses an inspection method including a step of preparing a cable and an inspection step of measuring irregularity of a surface of the cable on the basis of a change of a position that receives reflection light by irradiating the surface of the cable with laser light and receiving reflection light from the cable by a sensor while moving the cable in the longitudinal direction.

QIN XINYAN et al: "A novel method to reconstruct overhead high-voltage power lines using cable inspection robot LiDAR data", Remote Sensing, vol. 9, no. 7, 22 July 2017 page 753, discloses the extraction and reconstruction of power lines using a cable inspection robot LiDAR data.

CN 105 953 765 A discloses position detector for a steel pipe in a cable splicing sleeve based on synchronous belt driving.

HE HAOHUI et al: "Measurement of 3D shape of cable sealing layer based on structured light binocular vision", Spie Smart Structures and Materials + Nondestructive Evaluation and Health Monitoring, 2005, San Diego, California, United States, Spie, US, vol. 11781, 28 February 2021, discloses the use of a lattice laser to irradiate a target to form a laser lattice on the surface of the target to obtain a target image with a binocular polarization camera.

### Summary of the disclosure

In view of the above, a method for inspecting an insulation of a high voltage cable is described. The method includes a data acquisition including scanning a surface of a high voltage cable's insulation by at least one laser scanner. The scanning includes moving the at least one laser scanner and the high voltage cable relative to each other along a length direction of the high voltage cable. The method further includes a data evaluation including: generating a 3-dimensional model of the scanned surface based on the acquired data and comparing this generated model with a reference 3-dimensional model of a surface of a high voltage cable's insulation.

According to an aspect, a system for inspecting an insulation of a high voltage cable is provided. The system includes an apparatus including at least one scanning assembly for scanning a surface of the high voltage cable. The apparatus further includes an attachment assembly configured for attaching the at least one scanning assembly to the high voltage cable. The at least one scanning assembly includes a linear axis and a laser scanner attached to the linear axis. The linear axis is configured to provide linear motion to the laser scanner. For evaluating data acquired by the at least one scanning assembly: the apparatus includes an electronic circuit configured to carry out the data evaluation of the method described herein, or the apparatus is connectable to a computer for transferring the acquired data to the computer and the system further includes a computer program product comprising instructions which, when the computer program product is executed by a computer, cause the computer to carry out the data evaluation of the method described herein.

Further advantages, features, aspects and details that can be combined with embodiments described herein are evident from the dependent claims, claim combinations, the description and the drawings.

### Brief description of the Figures:

The details will be described in the following with reference to the figures, wherein
- Fig. 1: is a diagram illustrating a method for inspecting an insulation of a high voltage cable, according to aspects of the present disclosure;
- Fig. 2: is a schematic perspective view of a system for inspecting an insulation of a high voltage cable, according to embodiments of the present disclosure;
- Fig. 3: is a schematic cross-sectional view of the system shown in Fig. 2; and
- Fig. 4: is a schematic cross-sectional view of a system for inspecting an insulation of a high voltage cable, according to embodiments of the present disclosure.

### Detailed description of the Figures and of embodiments:

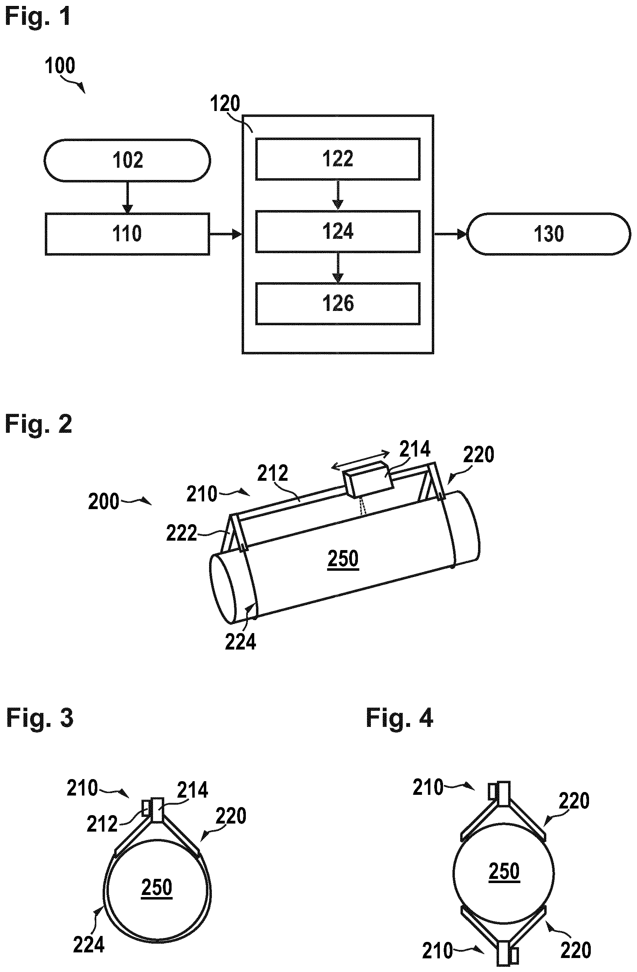

Reference will now be made in detail to the various embodiments, one or more examples of which are illustrated in each figure. Each example is provided by way of explanation and is not meant as a limitation. For example, features illustrated or described as part of one embodiment can be used on or in conjunction with any other embodiment to yield yet a further embodiment. It is intended that the present disclosure includes such modifications and variations. In particular, aspects relating to the systems described with regard to Figs. 2 - 4 may be incorporated into the method as described with regard to Fig. 1.

Within the following description of the drawings, the same reference numbers refer to the same or to similar components. Generally, only the differences with respect to the individual embodiments are described. Unless specified otherwise, the description of a part or aspect in one embodiment can be applied to a corresponding part or aspect in another embodiment as well.

In the context of the present disclosure, a high voltage (HV) may be understood as a voltage higher than 1 kV for alternating currents or higher than 1,5 kV for direct currents. Additionally, a medium voltage (MV) may be defined as a voltage higher than 1 kV and lower than for example 35, 38, or 52 kV, particularly for alternating currents. Methods and systems according to the present disclosure can be especially suitable for HV cables and extra high voltage (EHV) cables. In this regard, the HV range is particularly to be understood as extending from voltages of at least 52 kV to voltages up to 170 kV. The EHV range is particularly to be understood as a range including voltages higher than 170 kV. The EHV range may extend up to e.g. 550 kV for alternating currents and up to e.g. 640 kV, 800 kV, or 1100 kV for direct currents.

Fig. 1 is a diagram illustrating a method for inspecting an insulation of a high voltage cable, according to aspects of the present disclosure. The method starts in a block 102. The method includes, in a block 110, a data acquisition. The data acquisition includes scanning a surface of a HV cable's insulation by at least one laser scanner. The scanning includes moving the at least one laser scanner and the HV cable relative to each other along a length direction of the HV cable.

The operation of a laser scanner may be summarized as follows: A laser line is projected onto a surface of the inspected object by an optical system and the reflected light is registered by a sensor matrix. Through the principle of laser line triangulation, distance as well as position information can be acquired from the surface of the object.

The method further includes, in a block 120, a data evaluation. The data evaluation includes, in a block 122, generating a 3-dimensional model of the scanned surface based on the acquired data.

According to an aspect, the scanned surface may include a full circumference of the high voltage cable. Scanning the complete processed cable area and particularly generating a corresponding complete 3D model is beneficial for defining tolerances for the insulation's state after processing. Quality assurance can thus be improved. In contrast, conventional methods of inspecting an insulation of a HV cable are based on a very limited number of measurement points. Moreover, a repeated measurement will typically occur at a different position of the insulating layer than the previous measurement. Conventional methods thus have limitations as to the replicability of their results.

Moreover, with conventional methods for inspecting a high voltage cable's insulation, particularly manual measurements on a limited number of positions, irregularities such as indentations, scratches, cavities or elevations in or on the insulation surface can be overlooked. This poses a security risk, for example because air gaps could develop or lubricants like silicone oil could enter indentations, scratches or cavities in the insulating material. The irregularities can also cause partial discharges that contribute to aging and damage of insulating material. The methods and systems according to the present disclosure, providing a 3D model of the insulation's surface, can mitigate the risk of overlooking such irregularities or other faults in the insulation.

According to an aspect, generating the 3-dimensional model may include combining measurement data from at least e.g. two or three laser scanners. As an example, measurement data from two, three or four laser scanners may be combined. By combining measurement data from at least two laser scanners, data from a full circumference of the HV cable can be included in the 3-dimensional model.

As to this, generating the 3-dimensional model may additionally or alternatively include: combining measurement data from at least two scans performed by one laser scanner at different positions along a circumference of the HV cable. As an example, measurement data from two, three or four scans performed by one laser scanner may be combined.

The data evaluation further includes, in block 124, comparing the generated model with a reference 3-dimensional model. In particular, the generated model is examined for deviations from the reference model. A judgement about the state of the insulation surface can thus be made, based on a replicable measurement. It is made possible to define standard tolerances for the state of HV cable's insulation surface after processing.

The reference 3-dimensional model may be a partly predefined model of a surface of a high voltage cable's insulation. The partly predefined model may be adjusted based on the acquired data. For example, a diameter of the partly predefined model may be adjusted based on the acquired data. The diameter of the partly predetermined model may be adjusted based on at least one of: a minimum diameter and a maximum diameter of the high voltage cable determined from the acquired data.

According to an aspect, the data evaluation may further include, in block 126, determining a state of the insulation of the high voltage cable, particularly of the insulation's surface, according to predefined criteria. The judgment of processing result quality can thus be based on a replicable inspection method. The determination of the state of the insulation may include calculating distance values between points of the generated 3-dimensional model and the reference 3-dimensional model.

According to an aspect, the data evaluation may further include an identification of irregularities on the surface of the insulation of the high voltage cable according to predefined criteria. The irregularities particularly include any of: indentations, scratches, cavities, or elevations. The identification may be automatic. Security risks associated with irregularities on the insulation's surface can thus be revealed. The method concludes in a block 130.

Methods and system according to the present disclosure can provide an improved quality of processing during HV accessory installation, including type testing. The fast and reliable evaluation of processing result quality can lead to reductions of the time required for HV accessory installation. A further advantage is that if a scan shows that the surface of an HV cable already has the required level of quality after a peeling process, subsequent grinding may be omitted. Thus, time and effort may be saved.

According to an aspect, the scanned surface area has a length of at least for example 0,1, 0,2, or 0,3 m along a main direction of extension of the high voltage cable. The length may be smaller than for example 1,0, 0,75, or 0,6 m. Generally, a length of the processed cable section, i.e. the section where the outer conductive layer is removed, depends on the accessory to be installed on the cable. The length may be for example 0,3 m or 1,5 m. It is nonetheless possible to use the same methods and systems for these different cases, because only a section of approximately 0,5 m is particularly important for the electric properties.

Fig. 2 is a schematic perspective view of a system for inspecting an insulation of a HV cable 250. The system is particularly to be used for the method described with regard to Fig. 1. The system includes an apparatus 200 including at least one scanning assembly 210 for scanning a surface of the HV cable 250.

The at least one scanning assembly 210 includes a linear axis 212 and a laser scanner 214 attached to the linear axis 212. The linear axis 212 is configured to provide linear motion to the laser scanner 214. The linear axis may include a guide rail and a motor, particularly a servomotor. Fig. 3 is a schematic cross-sectional view of the system shown in Fig. 2, seen in a direction of the linear axis of the apparatus 200.

The apparatus 200 further includes an attachment assembly 220 configured for attaching the at least one scanning assembly 210 to the HV cable 250. The attachment assembly may include at least one pair of legs attached to the linear axis 212. As depicted, the attachment assembly 220 may include for example respectively one pair of legs 222 attached on each end of the linear axis 212. The legs 222 particularly hold the scanning assembly 210 at an appropriate distance from the HV cable 250.

For evaluating data acquired by the scanning assembly 210, the apparatus 200 further includes an electronic circuit configured to carry out the data evaluation of the method described with regard to Fig. 1, or the apparatus is connectable to a computer for transferring the acquired data to the computer and the system further includes a computer program product comprising instructions which, when the computer program product is executed by a computer, cause the computer to carry out the data evaluation of the method as described with regard to Fig. 1. The computer program product may be provided for example as a computer-readable data carrier having the computer program product stored thereon or as a data carrier signal carrying the computer program product. The apparatus connectable to a computer particularly includes a corresponding interface, for example an ethernet interface, for connecting the apparatus to a computer.

In embodiments, the apparatus includes a plurality of laser scanners, for example at least two, three, or four laser scanners. The plurality of laser scanners is configured to jointly scan a full circumference of the HV cable. As an example, three laser scanners may be positioned respectively 120° apart along a circumferential direction of the cable. As another example, four laser scanners may be positioned respectively 90° apart along a circumferential direction of the cable.

In embodiments, the attachment assembly 220 may include a strap 224 for attaching the at least one pair of legs to the HV cable. As shown in the depicted embodiment, the attachment assembly 220 may include respectively one strap 224 attached to each of the pairs of legs 222. In an assembled state, the strap 224 may lead around the HV cable 250 for attaching the pair of legs 222 to the HV cable 250.

Fig. 4 is a schematic cross-sectional view of a system for inspecting an insulation of a high voltage cable, according to embodiments of the present disclosure. As depicted, the system may include an apparatus including two scanning assemblies 210 for scanning a surface of the HV cable. In particular, each of the scanning assemblies includes a laser scanner and a linear axis. Each of the scanning assemblies 210 may be attached to the HV cable by a respective attachment assembly 220. The straps for attaching the attachment assembly's legs to the HV cable were omitted in the figure for clarity. The remaining features are at least substantially the same as described above with regard to Figs. 2 and 3.

## Claims

1. A method for inspecting an insulation of a high voltage cable, the method comprising:
a data acquisition comprising:
scanning a surface of a high voltage cable's insulation by at least one laser scanner, wherein the scanning comprises moving the at least one laser scanner and the high voltage cable relative to each other along a length direction of the high voltage cable; and
a data evaluation comprising:
generating a 3-dimensional model of the scanned surface based on the acquired data, and
comparing the generated model with a reference 3-dimensional model, which is a partly predefined model of a high voltage cable's insulation.

2. The method according to claim 1, wherein the scanned surface comprises a full circumference of the high voltage cable.

3. The method according to any of the preceding claims, wherein generating the 3-dimensional model comprises combining measurement data from at least two laser scanners.

4. The method according to any of the preceding claims, wherein the reference 3-dimensional model is a partly predefined model of a surface of a high voltage cable's insulation and wherein the partly predefined model is adjusted based on the acquired data.

5. The method according to claim 4, wherein a diameter of the partly predefined model is adjusted based on the acquired data.

6. The method according to claim 5, wherein the diameter is adjusted based on at least one of: a minimum diameter and a maximum diameter of the high voltage cable determined from the acquired data.

7. The method according to any of the preceding claims, wherein the data evaluation further includes determining a state of the insulation of the high voltage cable according to predefined criteria.

8. The method according to claim 7, wherein the determination of a state of the insulation includes: calculating distance values between points of the generated 3-dimensional model and the reference 3-dimensional model.

9. The method according to any of the preceding claims, wherein the data evaluation further includes an identification of irregularities on the surface of the insulation of the high voltage cable according to predefined criteria.

10. The method according to any of the preceding claims, wherein the scanned surface area has a length of at least 0,2 m along a main direction of extension of the high voltage cable.

11. System for inspecting an insulation of a high voltage cable, the system comprising:
an apparatus comprising:
at least one scanning assembly (210) for scanning a surface of the high voltage cable (250), and
an attachment assembly (220) configured for attaching the at least one scanning assembly (210) to the high voltage cable (250), wherein
the at least one scanning assembly (210) includes a linear axis (212) and a laser scanner (214) attached to the linear axis (212) and wherein the linear axis (212) is configured to provide linear motion to the laser scanner (214), wherein for evaluating data acquired by the at least one scanning assembly (210):
the apparatus comprises an electronic circuit configured to carry out the data evaluation of the method according to any of claims 1 to 11, or
the apparatus is connectable to a computer for transferring the acquired data to the computer and the system further includes a computer program product comprising instructions which, when the computer program product is executed by a computer, cause the computer to carry out the data evaluation of the method according to any of claims 1 to 10.

12. The system according to claim 11, wherein the apparatus includes at least two laser scanners (214), wherein the at least two laser scanners (214) are configured to jointly scan a full circumference of the high voltage cable.

13. The system according to any of claims 11 - 12, wherein the attachment assembly (220) includes at least one pair of legs attached to the linear axis.

14. The system according to claim 13, wherein the attachment assembly (220) includes a strap for attaching the at least one pair of legs to the high voltage cable.

## Patentansprüche

1. Verfahren zur Prüfung einer Isolation eines Hochspannungskabels, wobei das Verfahren Folgendes umfasst:
eine Datenerfassung, umfassend:
Abtastung einer Oberfläche der Isolation eines Hochspannungskabels durch mindestens einen Laserscanner, wobei die Abtastung die Bewegung des mindestens einen Laserscanners und des Hochspannungskabels relativ zueinander entlang einer Längsrichtung des Hochspannungskabels umfasst; und eine Datenauswertung, umfassend:
Erzeugung eines dreidimensionalen Modells der abgetasteten Oberfläche anhand der erfassten Daten, und
Vergleich des erzeugten Modells mit einem dreidimensionalen Referenzmodell, das ein teilweise vordefiniertes Modell der Isolation eines Hochspannungskabels ist.

2. Verfahren nach Anspruch 1, wobei die abgetastete Oberfläche einen vollen Umfang des Hochspannungskabels umfasst.

3. Verfahren nach einem der vorhergehenden Ansprüche, wobei die Erzeugung des dreidimensionalen Modells die Kombinierung von Messdaten von mindestens zwei Laserscannern umfasst.

4. Verfahren nach einem der vorhergehenden Ansprüche, wobei das dreidimensionale Referenzmodell ein teilweise vordefiniertes Modell einer Oberfläche der Isolation eines Hochspannungskabels ist, und wobei das teilweise vordefinierte Modell anhand der erfassten Daten eingestellt wird.

5. Verfahren nach Anspruch 4, wobei ein Durchmesser des teilweise vordefinierten Modells anhand der erfassten Daten eingestellt wird.

6. Verfahren nach Anspruch 5, wobei der Durchmesser anhand eines Mindestdurchmessers und/oder eines Maximaldurchmessers des Hochspannungskabels, die aus den erfassten Daten bestimmt wurden, eingestellt wird.

7. Verfahren nach einem der vorhergehenden Ansprüche, wobei die Datenauswertung ferner die Bestimmung eines Zustands der Isolation des Hochspannungskabels gemäß vordefinierten Kriterien beinhaltet.

8. Verfahren nach Anspruch 7, wobei die Bestimmung eines Zustands der Isolation Folgendes beinhaltet: Berechnung von Abstandswerten zwischen Punkten des erzeugten dreidimensionalen Modells und des dreidimensionalen Referenzmodells.

9. Verfahren nach einem der vorhergehenden Ansprüche, wobei die Datenauswertung ferner eine Identifikation von Unregelmäßigkeiten auf der Oberfläche der Isolation des Hochspannungskabels gemäß vordefinierten Kriterien beinhaltet.

10. Verfahren nach einem der vorhergehenden Ansprüche, wobei der abgetastete Oberflächenbereich eine Länge von mindestens 0,2 m entlang einer Haupterstreckungsrichtung des Hochspannungskabels aufweist.

11. System zur Prüfung der Isolation eines Hochspannungskabels, wobei das System Folgendes umfasst:
ein Gerät, umfassend:
mindestens eine Abtastanordnung (210) zur Abtastung einer Oberfläche des Hochspannungskabels (250), und
eine Befestigungsanordnung (220), die zur Befestigung der mindestens einen Abtastanordnung (210) an dem Hochspannungskabel (250) konfiguriert ist, wobei
die mindestens eine Abtastanordnung (210) eine Linearachse (212) und einen Laserscanner (214) beinhaltet, der an der Linearachse (212) befestigt ist, und wobei die Linearachse (212) so konfiguriert ist, dass sie eine Linearbewegung für den Laserscanner (214) bereitstellt, wobei zur Auswertung von Daten, die durch die mindestens eine Abtastanordnung (210) erfasst wurden, Folgendes gilt:
das Gerät eine elektronische Schaltung umfasst, die so konfiguriert ist, dass sie die Datenauswertung des Verfahrens nach einem der Ansprüche 1 bis 11 durchführt, oder
das Gerät mit einen Computer zur Übertragung der erfassten Daten an den Computer verbindbar ist, und das System ferner ein Computerprogrammprodukt beinhaltet, umfassend Befehle, die, wenn das Computerprogrammprodukt von einem Computer ausgeführt wird, den Computer veranlassen, die Datenauswertung des Verfahrens nach einem der Ansprüche 1 bis 10 durchzuführen.

12. System nach Anspruch 11, wobei das Gerät mindestens zwei Laserscanner (214) beinhaltet, wobei die mindestens zwei Laserscanner (214) so konfiguriert sind, dass sie gemeinsam einen vollen Umfang des Hochspannungskabels abtasten.

13. System nach einem der Ansprüche 11-12, wobei die Befestigungsanordnung (220) mindestens ein Paar von Stützen beinhaltet, die an der Linearachse befestigt sind.

14. System nach Anspruch 13, wobei die Befestigungsanordnung (220) einen Riemen zur Befestigung des mindestens einen Paares von Stützen an dem Hochspannungskabel beinhaltet.

## Revendications

1. Procédé d'inspection d'une isolation d'un câble haute tension, le procédé comprenant :
une acquisition de données comprenant :
le balayage d'une surface d'une isolation d'un câble haute tension par au moins un dispositif de balayage laser, dans lequel le balayage comprend le déplacement de l'au moins un dispositif de balayage laser et du câble haute tension l'un par rapport à l'autre selon une direction de longueur du câble haute tension ; et une évaluation de données comprenant :
la génération d'un modèle tridimensionnel de la surface balayée sur la base des données acquises, et
la comparaison du modèle généré à un modèle tridimensionnel de référence, qui est un modèle partiellement prédéfini d'une isolation de câble haute tension.

2. Procédé selon la revendication 1, dans lequel la surface balayée comprend une circonférence complète du câble haute tension.

3. Procédé selon l'une quelconque des revendications précédentes, dans lequel la génération du modèle tridimensionnel comprend la combinaison de données de mesure provenant d'au moins deux dispositifs de balayage laser.

4. Procédé selon l'une quelconque des revendications précédentes, dans lequel le modèle tridimensionnel de référence est un modèle partiellement prédéfini d'une surface d'une isolation de câble haute tension et dans lequel le modèle partiellement prédéfini est ajusté sur la base des données acquises.

5. Procédé selon la revendication 4, dans lequel un diamètre du modèle partiellement prédéfini est ajusté sur la base des données acquises.

6. Procédé selon la revendication 5, dans lequel le diamètre est ajusté sur la base d'au moins l'un parmi : un diamètre minimal et un diamètre maximal du câble haute tension déterminé à partir des données acquises.

7. Procédé selon l'une quelconque des revendications précédentes, dans lequel l'évaluation de données inclut en outre la détermination d'un état de l'isolation du câble haute tension selon des critères prédéfinis.

8. Procédé selon la revendication 7, dans lequel la détermination d'un état de l'isolation inclut : le calcul de valeurs de distance entre des points du modèle tridimensionnel généré et du modèle tridimensionnel de référence.

9. Procédé selon l'une quelconque des revendications précédentes, dans lequel l'évaluation de données inclut en outre une identification d'irrégularités sur la surface de l'isolation du câble haute tension selon des critères prédéfinis.

10. Procédé selon l'une quelconque des revendications précédentes, dans lequel l'aire de surface balayée présente une longueur d'au moins 0,2 m selon une direction principale d'extension du câble haute tension.

11. Système d'inspection d'une isolation d'un câble haute tension, le système comprenant :
un appareil comprenant :
au moins un ensemble de balayage (210) pour balayer une surface du câble haute tension (250), et
un ensemble de fixation (220) configuré pour fixer l'au moins un ensemble de balayage (210) au câble haute tension (250), dans lequel
l'au moins un ensemble de balayage (210) inclut un axe linéaire (212) et un dispositif de balayage laser (214) fixé à l'axe linéaire (212) et dans lequel l'axe linéaire (212) est configuré pour fournir un mouvement linéaire au dispositif de balayage laser (214), dans lequel pour l'évaluation de données acquises par l'au moins un ensemble de balayage (210) :
l'appareil comprend un circuit électronique configuré pour réaliser l'évaluation de données du procédé selon l'une quelconque des revendications 1 à 11, ou
l'appareil peut être relié à un ordinateur pour transférer les données acquises à l'ordinateur et le système inclut en outre un produit de programme informatique comprenant des instructions qui, lorsque le produit de programme informatique est exécuté par un ordinateur, amènent l'ordinateur à réaliser l'évaluation de données du procédé selon l'une quelconque des revendications 1 à 10.

12. Système selon la revendication 11, dans lequel l'appareil inclut au moins deux dispositifs de balayage laser (214), dans lequel les au moins deux dispositifs de balayage laser (214) sont configurés pour balayer conjointement une circonférence complète du câble haute tension.

13. Procédé selon l'une quelconque des revendications 11 et 12, dans lequel l'ensemble de fixation (220) inclut au moins une paire de branches fixées à l'axe linéaire.

14. Système selon la revendication 13, dans lequel l'ensemble de fixation (220) inclut une sangle pour fixer l'au moins une paire de branches au câble haute tension.
